# EUROPEAN PATENT APPLICATION

(11) **EP 4 567 881 A1**
(43) Date of publication of application: **11.06.2025**
(21) Application number: 24216833.4
(22) Date of filing: 02.12.2024
(51) Int. Cl.: H01L 23/48, H01L 23/538, H01L 25/07, H01L 23/367, H01L 23/498

(54) **POWER SEMICONDUCTOR MODULE, POWER SEMICONDUCTOR MODULE HEAT DISSIPATION PACKAGING STRUCTURE, AND ELECTRODE CONTROLLER**

(30) Priority: 04.12.2023 CN 202311654572; 04.12.2023 CN 202323302925 U; 04.12.2023 CN 202311654603; 04.12.2023 CN 202323299793 U; 04.12.2023 CN 202311648242
(71) Applicant: HUNAN SAN'AN SEMICONDUCTOR CO., LTD., Changsha, Hunan (CN)
(72) Inventor: YAO, Chen, High Tech Development Zone Changsha (CN); CAI, Wenbi, High Tech Development Zone Changsha (CN); CHIANG, Hsiehlung, High Tech Development Zone Changsha (CN); LIN, Zhidong, High Tech Development Zone Changsha (CN); SHI, Hongliang, High Tech Development Zone Changsha (CN); CHEN, Si, High Tech Development Zone Changsha (CN); YANG, Ning, High Tech Development Zone Changsha (CN)
(74) Representative: Herrero & Asociados, S.L.

(57) **Abstract**

The present application provides a power semiconductor module (100), which relates to the field of electrical component technology. The power semiconductor module (100) includes a substrate (110), a DC+ liner plate (111), a DC- liner plate (113), and an AC liner plate (115). The substrate (110) is divided into multiple areas, and mutually isolated the DC+ liner plate (111), the DC- liner plate (113), and the AC liner plate (115) are disposed on a surface of the substrate (110). Compared to the related art, in the power semiconductor module (100) of the present application, the DC+ liner plate (111), the DC- liner plate (113), and the AC liner plate (115) can be reasonably arranged without interfering with one another, which facilitates wiring. Furthermore, the risk of the short circuit is reduced due to the minimized interference between the positive electrode and the negative electrode.

## Description

### TECHNICAL FIELD

The present disclosure relates to the field of electrical component technologies, and in particular to a power semiconductor module, a power semiconductor module heat dissipation packaging structure, and an electrode controller.

### BACKGROUND

With the enhancement of performance of a new energy vehicle, the requirements for a driving circuit system are also increasing. A power semiconductor module, as a key component in the driving circuit system, has a significant impact on the performance of the driving circuit system. Therefore, it is necessary to further develop and improve semiconductor packaging used in these driving circuit systems. For example, the driving circuit system may be a motor controller that converts a direct current voltage of a power battery into an alternating voltage required by a three-phase driving motor. The motor controller with high-performance requires a compact structure to achieve high power density, and requires a large current-carrying capacity to achieve high acceleration performance.

In related art, the motor controller may be implemented through appropriate circuits in a power semiconductor module packaging structure. Through the inventor's research, it has been found that the power semiconductor module in the related art has complex internal circuit layouts, and the layout of each wiring terminal is messy. The same conductive layer usually needs to adopt a split copper structure and be electrically connected as a whole through bonding, which results in further complexity in the structure and a complex manufacturing process.

### SUMMARY OF THE DISCLOSURE

The purpose of the present disclosure includes, for example, providing a power semiconductor module that can reasonably arrange internal circuits and terminals, making the overall structure compact, so that the overall structure occupies less space. It is also convenient for wiring. The risk of the short circuit is reduced due to minimized interference between the positive electrode and the negative electrode. Furthermore, it can make a layout of terminal interfaces more reasonable.

The embodiments of the present disclosure can be implemented as follows.

The embodiments of the present disclosure provide a power semiconductor module. The power semiconductor module includes a substrate, a DC+ liner plate, a DC- liner plate, and an AC liner plate.

The substrate includes a first side and a second side opposite to each other in a first direction, a third side and a fourth side opposite to each other in a second direction. The first side, the second side, the third side and the fourth side are connected end-to-end. In the first direction, the substrate is configured as a first area and a second area opposite to each other. The first area is disposed on a side where the first side is located, and the second area is disposed on a side where the second side is located.

The DC+ liner plate, a DC- liner plate, and an AC liner plate are disposed on the substrate. The DC+ liner plate, the DC- liner plate, and the AC liner plate are configured to be electrically isolated from one another on the substrate.

The AC liner plate is disposed in the first area and the second area, and configured to extend from a side of the first area close to the first side to the second area.

The DC+ liner plate is disposed in the first area and configured to be surrounded by the AC liner plate.

The DC- liner plate is disposed in the second area and configured to surround the AC liner plate.

Different from the related art, the effects of the present disclosure are as follows.

In the power semiconductor module provided by the embodiments of the present disclosure, the substrate is divided into multiple areas. The substrate is configured as the first area and the second area in the first direction. The DC+ liner plate, the DC- liner plate, and the AC liner plate are disposed on the surface of the substrate. The DC+ liner plate, the DC- liner plate, and the AC liner plate are isolated from one another or spaced apart from one another. The AC liner plate is disposed in the first area and the second area. The AC liner plate is configured to extend from the side of the first area close to the first side to the second area. The DC+ liner plate is disposed in the first area and configured to be surrounded by the AC liner plate. The DC- liner plate is disposed in the second area and configured to surround the AC liner plate, making the layout more compact. Compared to the related art, in the power semiconductor module in the embodiments of the present disclosure, the DC+ liner plate, the DC- liner plate, and the AC liner plate can be reasonably arranged without interfering with one another, which facilitates wiring. Furthermore, the risk of the short circuit is reduced due to the minimized interference between the positive electrode and the negative electrode. Moreover, the AC liner plate may be the single piece of copper-clad area that extends continuously from the first area to the second area of the substrate, avoiding the bonding structure caused by the split, further simplifying the layout of the wiring terminals, and reducing the difficulty of the manufacturing process.

### BRIEF DESCRIPTION OF THE DRAWINGS

In order to more clearly describe the technical solutions in some embodiments of the present disclosure, hereinafter, the accompanying drawings that are used in some embodiments will be briefly described. It should be understood that the following accompanying drawings only illustrate some embodiments of the present disclosure and should not be considered as limiting the scope. For those of ordinary skill in the art, other accompanying drawings may be obtained based on these accompanying drawings without any creative efforts.
FIG. 1 is an internal structural schematic view of a power semiconductor module in some embodiments of the present disclosure.
FIG. 2 is an internal assembly structural schematic view of the power semiconductor module in some embodiments of the present disclosure.
FIG. 3 is an internal exploded structural schematic view of the power semiconductor module in some embodiments of the present disclosure.
FIG. 4 is a structural schematic view of a DC+ terminal in FIG. 3.
FIG. 5 is a structural schematic view of a DC- terminal in FIG. 3.
FIG. 6 is a structural schematic view of an AC terminal in FIG. 3.
FIG. 7 is an external structural schematic view of the power semiconductor module in some embodiments of the present disclosure.
FIG. 8 is a cross-sectional structural schematic view of the power semiconductor module in some embodiments of the present disclosure.
FIG. 9 is a structural schematic view illustrating a substrate connection of the power semiconductor module in some embodiments of the present disclosure.
FIG. 10 is a structural schematic view illustrating the substrate connection of the power semiconductor module in some embodiments of the present disclosure.
FIG. 11 is a structural schematic view of a power module heat dissipation packaging structure from a first perspective in some embodiments of the present disclosure.
FIG. 12 is a structural schematic view of the power module heat dissipation packaging structure from a second perspective in some embodiments of the present disclosure.
FIG. 13 is an exploded structural schematic view of the power module heat dissipation packaging structure in some embodiments of the present disclosure.
FIG. 14 is a structural schematic view of a motor controller in some embodiments of the present disclosure.
FIG. 15 is an assembly schematic view of a busbar capacitor ring and the power module heat dissipation packaging structure in FIG. 14.
FIG. 16 is a structural schematic view of an electric drive assembly in some embodiments of the present disclosure.

### DETAILED DESCRIPTION

It should be noted that features in the embodiments of the present disclosure may be combined with each other without conflict.

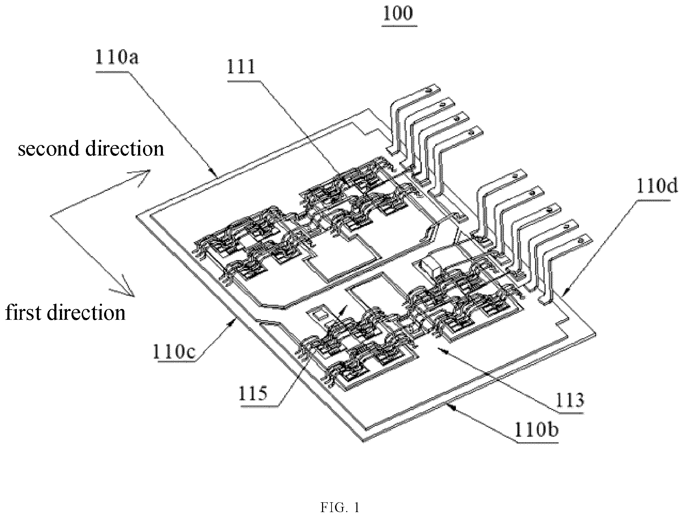

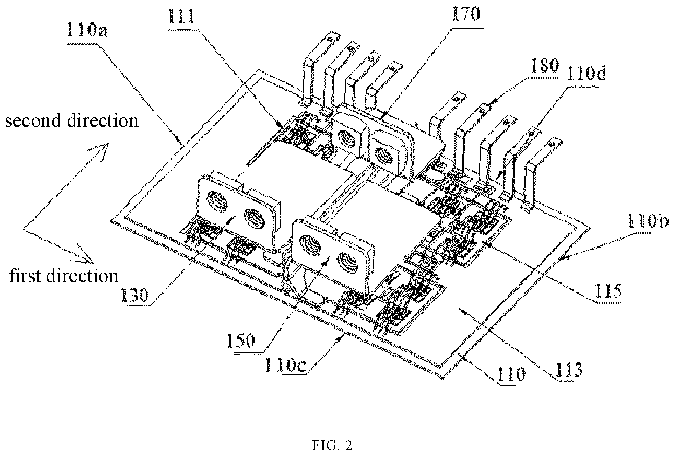

As illustrated in FIG. 1 to FIG. 5, the embodiments provide a power semiconductor module 100. In the power semiconductor module 100, internal circuits and terminals may be reasonably arranged, so that an overall structure of the power semiconductor module 100 is simple and compact, and occupies less space. The overall structure of the power semiconductor module 100 is also convenient for wiring. The risk of the short circuit is reduced due to minimized interference between the positive electrode and the negative electrode. Furthermore, it can make a terminal interface layout more reasonable, and reduce manufacturing difficulty.

The embodiments of the present disclosure provide the power semiconductor module 100. The power semiconductor module 100 includes a substrate 110, a DC+ liner plate 111, a DC- liner plate 113, and an AC liner plate 115.

The substrate 110 includes a first side 110a and a second side 110b that are opposite to each other in a first direction, and a third side 110c and a fourth side 110d that are opposite to each other in a second direction. The first side 110a, the second side 110b, the third side 110c, and the fourth side 110d are connected end-to-end. In the first direction, the substrate 110 is configured as a first area and a second area that are opposite to each other. That is, the substrate 110 includes the first area and the second area. The first area is disposed on the side where the first side 110a is located, and the second area is disposed on the side where the second side 110b is located.

The DC+ liner plate 111, the DC- liner plate 113, and the AC liner plate 115 are disposed on the substrate 110. On the substrate 110, the DC+ liner plate 111, the DC- liner plate 113, and the AC liner plate 115 are configured to be isolated from one another or spaced apart from one another

The AC liner plate 115 is disposed in the first area and the second area. The AC liner plate 115 is configured to extend from a side of the first area close to the first side 110a to the second area.

The DC+ liner plate 111 is disposed in the first area and configured to be surrounded by the AC liner plate 115.

The DC- liner plate 113 is disposed in the second area and configured to surround the AC liner plate 115.

In some embodiments, the substrate 110 may be in the form of a rectangular block. The first side 110a, the second side 110b, the third side 110c, and the fourth side 110d are four side edges of the substrate 110, respectively. The first side 110a and the second side 110b may be distributed left and right, the third side 110c and the fourth side 110d may be distributed front and back, and the first area and the second area may be distributed left and right on the substrate 110. The DC+ liner plate 111, the DC- liner plate 113, and the AC liner plate 115 are arranged reasonably on the substrate 110 and do not interfere with one another, which facilitates wiring. Furthermore, the risk of the short circuit is reduced due to the minimized interference between the positive electrode and the negative electrode. Moreover, the AC liner plate 115 may be a single piece of copper-clad area that extends continuously from the first area to the second area of the substrate 110, avoiding the bonding structure caused by the split, further simplifying the layout of the wiring terminals, and reducing the difficulty of the manufacturing process.

In some embodiments, a terminal installation area is disposed in a peripheral area where the first area is connected to the second area. An AC terminal 170, a DC+ terminal 130, and a DC- terminal 150 are disposed in the terminal installation area. The AC terminal 170 is disposed on the AC liner plate 115 in the terminal installation area, the DC+ terminal 130 is disposed on the DC+ liner plate 111 in the terminal installation area, and the DC- terminal 150 is disposed on the DC- liner plate 113 in the terminal installation area.

In some embodiments, the DC+ terminal 130 and the DC- terminal 150 are located in the first area and the second area, respectively, and do not interfere with each other, which facilitates wiring. Furthermore, the risk of the short circuit is reduced due to the minimized interference between the positive electrode and the negative electrode. In addition, by reasonably arranging the AC terminal 170, the AC terminal 170 can be compactly disposed between the first area and the second area, and the DC+ terminal 130 and the DC- terminal 150 are disposed side by side. Therefore, the overall structure is compact and occupies less space, and the layout of the terminal interface is more reasonable, which is conducive to external connection.

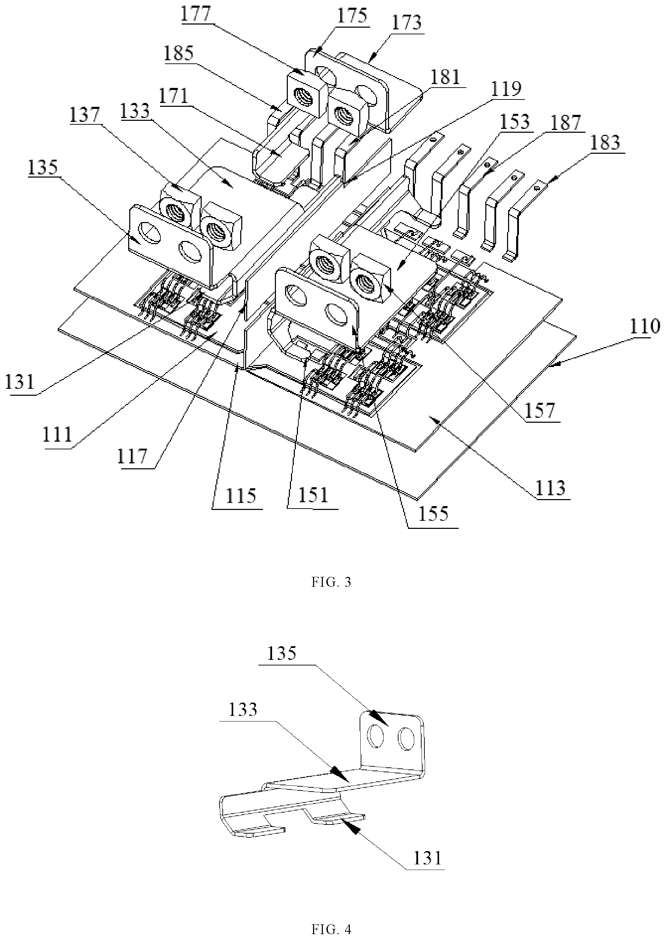

As illustrated in FIG. 3 and FIG. 4, in some embodiments, the DC+ terminal 130 includes a positive direct current pin 131, a positive terminal board 133, and a positive half bridge board 135. The positive terminal board 133 is spaced apart from the substrate 110. One end of the positive direct current pin 131 is connected to the positive terminal board 133, and the other end of the positive direct current pin 131 is connected to the DC+ liner plate 111 in the terminal installation area. The positive half bridge board 135 is disposed on an edge of the positive terminal board 133 close to the third side 110c, and extends along a direction away from the substrate 110. In some embodiments, the positive direct current pin 131, the positive terminal board 133, and the positive half bridge plate 135 are integrated. The positive direct current pin 131 is directly welded to the DC+ liner plate 111. The positive half bridge plate 135 is further provided with a positive connection nut 137, so that the positive half bridge plate 135 is connected to an external line.

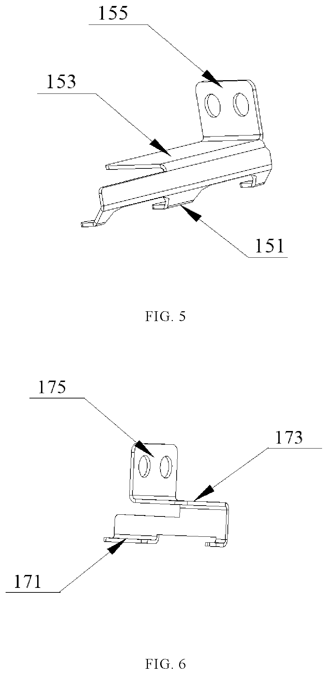

As illustrated in FIG. 3 and FIG. 5, the DC- terminal 150 includes a negative direct current pin 151, a negative terminal board 153, and a negative half bridge board 155. The negative terminal board 153 is spaced apart from the substrate 110. One end of the negative direct current pin 151 is connected to the negative terminal board 153, and the other end of the negative direct current pin 151 is connected to the DC- liner plate 113 in the terminal installation area. The negative half bridge plate 155 is disposed on an edge of the negative terminal board 153 close to the third side 110c, and extends along the direction away from the substrate 110. In some embodiments, the negative direct current pin 151, the negative terminal board 153, and the negative half bridge plate 155 are integrated. The negative direct current pin 151 is directly welded to the DC- liner plate 113. The negative half bridge plate 155 is further provided with a negative connection nut 157, so that the negative half bridge plate 155 is connected to the external line.

As illustrated in FIG. 3 and FIG. 6, the AC terminal 170 includes an alternating current pin 171, an alternating current terminal board 173, and an AC half bridge board 175. The alternating current terminal board 173 is spaced apart from the substrate 110. One end of the alternating current pin 171 is connected to the alternating current terminal board 173, and the other end of the alternating current pin 171 is connected to the AC liner plate 115 in the terminal installation area. The AC half bridge board 175 is disposed on an edge of the alternating current terminal board 173 close to the third side 110c, and extends along the direction away from the substrate 110. In some embodiments, the alternating current pin 171, the alternating current terminal board 173, and the AC half bridge board 175 are integrated. The alternating current pin 171 is directly welded to the AC liner plate 115. An alternating connection nut 177 is further disposed on the AC half bridge board 175, so that the AC half bridge board 175 is connected to the external line.

In some embodiments, the DC+ terminal 130, DC- terminal 150, and the AC terminal 170 are all copper bar terminals, and the copper bar terminals have good conductivity.

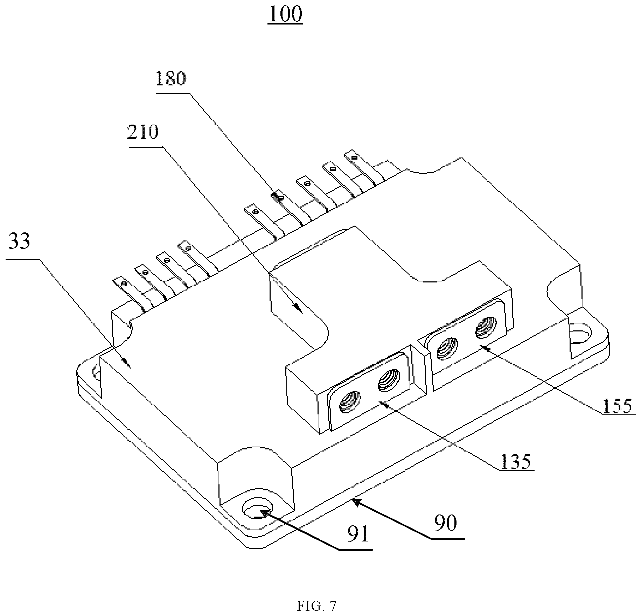

As illustrated in FIG. 3 and FIG. 7, in some embodiments, the negative half bridge plate 155 and the positive half bridge plate 135 are spaced apart from each other along the first direction. A distance between the negative half bridge plate 155 and the AC half bridge plate 175 is equal to a distance between the positive half bridge plate 135 and the AC half bridge plate 175. That is, the negative half bridge board 155 and the positive half bridge board 135 are disposed side by side at intervals. The negative half bridge board 155 and the positive half bridge board 135 are disposed on the same plane. Therefore, when the external line is connected to the negative half bridge board 155 and another external line is connected to the positive half bridge board 135, it is convenient for the external lines to be connected to the same plane, thereby facilitating wiring. Furthermore, the spaces occupied by the negative half bridge board 155 and the positive half bridge board 135 are further reduced. Moreover, it can be convenient for the DC+ terminal 130 and the DC- terminal 150 to be disposed side by side, so that the structure is compact and the electrical performance is improved.

In some embodiments, the AC half bridge board 175 is disposed parallel to both the positive half bridge board 135 and the negative half bridge board 155. In some embodiments, the AC half bridge board 175 adopts a parallel method to achieve terminal pulling out, so that wiring of direct current and wiring of alternating current can be achieved on two opposite sides of the AC half bridge board 175, which is more convenient for external line connection. A housing 33 may be disposed on the substrate 110. The DC+ liner plate 111, the DC- liner plate 113, and the AC liner plate 115 are disposed in the housing 33. The housing 33 partially protrudes along the direction away from the substrate 110, to form a housing protrusion 35. The DC+ terminal 130, the DC- terminal 150, and the AC terminal 170 correspond to and are accommodated in the housing 33. The AC half bridge plate 175, the positive half bridge plate 135, and the negative half bridge plate 155 correspond to and extend out of the housing protrusion 35, respectively, so as to achieve the wiring of the direct current and the wiring of the alternating current.

In some embodiments, every two of the positive terminal board 133, the negative terminal board 153, and the alternating current terminal board 173 are spaced apart from each other. A distance between the positive terminal board 133 and the substrate 110, a distance between the negative terminal board 153 and the substrate 110, and a distance between the alternating current terminal board 173 and the substrate 110 are all equal.

In some embodiments, one end of the positive direct current pin 131 is connected to an edge of the positive terminal board 133 close to the negative terminal board 153, and the positive direct current pin 131 is bent and extends towards the first side 110a. That is, the positive direct current pin 131 first extends along a direction away from the positive terminal board 133 and close to the substate 110, and then extends along a direction close to the first side 110a. The other end of the positive direct current pin 131 is connected to the DC+ liner plate 111 in the terminal installation area. One end of the negative direct current pin 151 is connected to an edge of the negative terminal board 153 close to the positive terminal board 133, and the negative direct current pin 151 is bent and extends towards the second side 110b. That is, the negative direct current pin 151 first extends along a direction away from the negative terminal board 153 and close to the substate 110, and then extends along a direction close to the second side 110b. The other end of the negative direct current pin 151 is connected to the DC- liner plate 113 in the terminal installation area. One end of the alternating current pin 171 is connected to an edge of the alternating current terminal board 173 close to the first side 110a, and the alternating current pin 171 is bent and extends towards the second side 110b. That is, the alternating current pin 171 first extends along a direction away from the alternating current terminal board 173 and close to the substate 110, and then extends along the direction close to the second side 11 0b. The other end of the alternating current pin 171 is connected to the AC liner plate 115 in the terminal installation area. In some embodiments, the positive direct current pin 131 and the negative direct current pin 151 are close to each other. The positive direct current pin 131 is bent along a direction, and the negative direct current pin 151 is bent along another direction that is opposite to the direction of bending the positive direct current pin 131. Therefore, the range of the overall welding area can be reduced during actual welding, and the impact of welding on the circuit can be reduced. Moreover, both the positive direct current pin 131 and the negative direct current pin 151 are directly welded to achieve a fixed electrical connection. Therefore, compared to bonded copper and aluminum for transition in the related art, it can achieve lower resistance impedance and higher resistance to surge current impact.

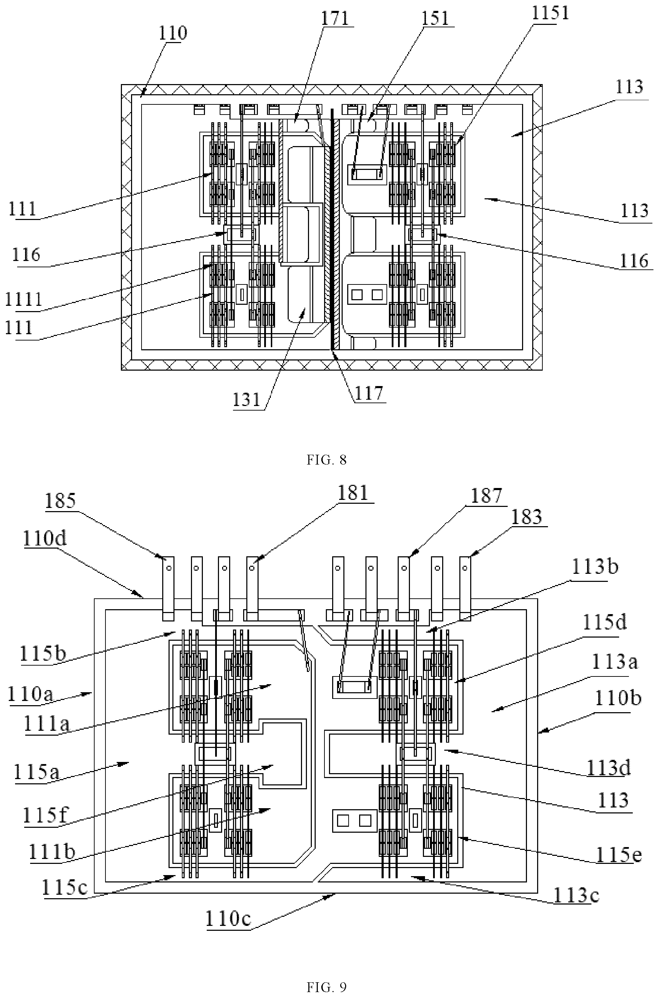

As illustrated in FIG. 3 and FIG. 8, in some embodiments, the power semiconductor module 100 further includes an isolation board 117 disposed between the DC+ terminal 130 and the DC- terminal 150. The DC+ terminal 130 and the DC- terminal 150 are disposed on two opposite sides of the isolation board 117, respectively. The AC terminal 170 is disposed across the isolation board 117. In some embodiments, the isolation board 117 may be made of an insulating material, and bonded or welded to the substrate 110, thereby further achieving electrical isolation between the DC+ terminal 130 and the DC- terminal 150. Moreover, the isolation board 117 is disposed, and the DC+ terminal 130 and the DC- terminal 150 are respectively disposed on two opposite sides of the isolation board 117, which is conductive to the mutual cancellation of copper bar terminal inductance of the power semiconductor module 100 during rapid commutation. It can achieve lower stray inductance, effectively reduce a peak voltage during operation, and improve device reliability.

In some embodiments, the DC+ terminal 130 and the DC- terminal 150 are respectively disposed on two opposite sides of the isolation board 117, and a height of the isolation board 117 is at least the same as a height of the positive terminal board 133 and a height of the negative terminal board 153. That is, the isolation board 117 may at least separate the positive terminal board 133 and the negative terminal board 153, and also separate the positive direct current pin 131 and the negative direct current pin 151, so as to achieve electrical isolation.

In some embodiments, the isolation board 117 defines a positioning groove 119, and a middle part of the AC terminal 170 is installed in the positioning groove 119. In some embodiments, the alternating current terminal board 173 of the AC terminal 170 is connected across the isolation board 117, and the middle part of the alternating current terminal board 173 is installed in the positioning groove 119. On one hand, by disposing the positioning groove 119, a position of the alternating current terminal board 173 may be limited to a certain extent, which facilitates rapid positioning of the alternating current terminal board 173. On the other hand, it also reduces a height of the alternating current terminal board 173, so that the alternating current terminal board 173 can be on the same horizontal plane as the positive terminal board 133 and the negative terminal board 153, further reducing the overall height and making the structure more compact.

As illustrated in FIG. 3, FIG. 8, and FIG. 9, in some embodiments, the AC liner plate 115 includes a first section 115a disposed in the first area, a second section 115b disposed in the first area, a third section 115c disposed in the first area, a fourth section 115d disposed in the second area, a fifth section 115e disposed in the second area, and a sixth section 115f disposed in the first area. The first section 115a is arranged close to the first side 110a and extends along the second direction. The second section 115b and the third section 115c extend from two opposite sides of the first section 115a in the second direction. The second section 115b and the third section 115c are configured to extend towards the second area along the third side 110c and the fourth side 110d, respectively. The fourth section 115d and the fifth section 115e extend from the second section 115b and the third section 115c, respectively. At a junction of the first area and the second area, the fourth section 115d and the fifth section 115e are integrated along the second direction. The sixth section 115f extends from a middle section of the first section 115a in the second direction and extends along the first direction towards the second area.

The DC+ liner plate 111 includes a seventh section 111a and an eighth section 111b. At the junction of the first area and the second area, the seventh section 111a and the eighth section 111b are integrated along the second direction.

The DC liner plate 113 includes a ninth section 113a, a tenth section 113b, an eleventh section 113c, and a twelfth section 113d. The ninth section 113a is disposed close to the second side 110b and extends along the second direction. The tenth section 113b and the eleventh section 113c extend from two opposite sides of the ninth section 113a in the second direction. The tenth section 113b and the eleventh section 113c are configured to extend towards the first area along the third side 110c and the fourth side 110d, respectively. The twelfth section 113d extends from a middle section of the ninth section 113a in the second direction and extends towards the first area along the first direction.

In some embodiments, the seventh section 111a and the eighth section 111b are mirror symmetrical with respect to a mid-vertical plane of the first side 110a, and the fourth section 115d and the fifth section 115e are mirror symmetrical with respect to a mid-vertical plane of the second side 110b.

In some embodiments, the fourth section 115d and the fifth section 115e are provided with a first power chip 1151, and the seventh section 111a and the eighth section 111b are provided with a second power chip 1111. Due to the mirror symmetry of the fourth section 115d and the fifth section 115e, and the mirror symmetry of the seventh section 111a and the eighth section 111b, it is conducive to parallel connection and current sharing between the first power chip 1151 and the second power chip 1111, thereby improving the reliability of the device.

In some embodiments, multiple control terminal pins 180 are further disposed on a part of the substrate 110 close to the fourth side 110d, and the multiple control terminal pins 180 bend along a direction away from the third side 110c. In some embodiments, the control terminal pins 180 are concentrated on a side edge of the substrate 110, located on a side of the AC terminal 170, and bend and extend along the direction away from the substrate 110. An extending direction of the control terminal pin 180 is opposite to an outlet direction of the DC+ terminal 130 and an outlet direction of the DC- terminal 150. The extending direction of the control terminal pin 180 is different from connection directions among the DC+ terminal 130, the DC- terminal 150, and the AC terminal 170, which weakens the electromagnetic interference of the power terminal on the control terminal.

In some embodiments, the multiple control terminal pins 180 include DC+ terminal pins 181, DC- terminal pins 183, and AC terminal pins 185. The AC terminal pin 185 is connected to the third section 115c, the DC+ terminal pin 181 is connected to the seventh section 111a, and the DC- terminal pin 183 is connected to the eleventh section 113c. In some embodiments, the DC+ terminal pin 181 is electrically connected to the DC+ liner plate 111, located on an edge of the third section 115c of the AC liner plate 115, and adjacent to the AC terminal pin 185. The DC terminal pin 183 is electrically connected to the DC- liner plate 113 and located on an edge of the eleventh section 113c of the DC- liner plate 113. The AC terminal pin 185 is disposed on an end of the substrate 110 close to the first side 110a, and the DC terminal pin 183 is disposed on an end on the substrate 110 close to the second side 11 0b. The AC terminal pin 185 is electrically connected to the AC liner plate 115 and located on an edge of the third section 115c of the AC liner plate 115, thereby achieving overall electrical connection and control.

In some embodiments, the DC+ terminal pin 181 is connected to the seventh section 111a through a bonding wire. In some embodiments, since the DC+ terminal pin 181 is separated from the seventh section 111a by the third section 115c, electrical connection can be achieved through the bonding wire.

In some embodiments, a gate conductive layer 116 is disposed on the surface of the substrate 110. The gate conductive layer 116 is spaced apart from each of the DC+ liner plate 111, the DC- liner plate 113, and the AC liner plate 115. The multiple control terminal pins 180 further include gate terminal pins 187, the gate terminal pins 187 are connected to the gate conductive layer 116 through bonding wires.

In some embodiments, the present disclosure further provides another power semiconductor module 100, whose basic structure, principle, and technical effects are the same as those of the aforementioned power semiconductor module 100. For the sake of a brief description, the corresponding content in the aforementioned description of the power semiconductor module 100 may be referred to the parts not mentioned in the description of the another power semiconductor module 100.

As illustrated in FIG. 1 to FIG. 9, another power semiconductor module 100 in the embodiments of the present disclosure includes the substrate 110, the DC+ liner plate 111, the DC- liner plate 113, and the AC liner plate 115.

The substrate 110 includes the first side 110a and the second side 110b that are opposite to each other in the first direction, and the third side 110c and the fourth side 110d that are opposite to each other in the second direction. The first side 110a, the second side 110b, the third side 110c, and the fourth side 110d are connected end-to-end. In the first direction, the substrate 110 is configured as the first area and the second area that are opposite to each other. That is, the substrate 110 includes the first area and the second area. The first area is disposed on the side where the first side 110a is located, and the second area is disposed on the side where the second side 110b is located.

The DC+ liner plate 111, the DC- liner plate 113, and the AC liner plate 115 are disposed on the substrate 110. On the substrate 110, the DC+ liner plate 111, the DC- liner plate 113, and the AC liner plate 115 are configured to be isolated from one another or spaced apart from one another

The AC liner plate 115 includes the first section 115a disposed in the first area, the second section 115b disposed in the first area, the third section 115c disposed in the first area, the fourth section 115d disposed in the second area, the fifth section 115e disposed in the second area, and the sixth section 115f disposed in the first area. The first section 115a is arranged close to the first side 110a and extends along the second direction. The second section 115b and the third section 115c respectively extend from two opposite sides of the first section 115a in the second direction. The second section 115b and the third section 115c are configured to extend towards the second area along the third side 110c and the fourth side 110d, respectively. The fourth section 115d and the fifth section 115e extend from the second section 115b and the third section 115c, respectively. At the junction of the first area and the second area, the fourth section 115d and the fifth section 115e are integrated along the second direction. The sixth section 115f extends from the middle section of the first section 115a in the second direction and extends towards the second area along the first direction.

The DC+ liner plate 111 is disposed in the first area and configured to be surrounded by the AC liner plate 115. The DC+ liner plate 111 includes the seventh section 111a and the eighth section 111b. At the junction of the first area and the second area, the seventh section 111a and the eighth section 111b are integrated along the second direction.

The DC liner plate 113 is disposed in the second area and configured to surround the AC liner plate 115. The DC liner plate 113 includes the ninth section 113a, the tenth section 113b, the eleventh section 113c, and the twelfth section 113d. The ninth section 113a is disposed close to the second side 110b and extends along the second direction. The tenth section 113b and the eleventh section 113c respectively extend from two opposite sides of the ninth section 113a in the second direction. The tenth section 113b and the eleventh section 113c are configured to extend towards the first area along the third side 110c and the fourth side 110d, respectively. The twelfth section 113d extends from the middle section of the ninth section 113a in the second direction and extends towards the first area along the first direction.

In some embodiments, an installation area of the AC terminal 170 is disposed in the peripheral area of one or more of the second section 115b, the third section 115c, the fourth section 115d, the fifth section 115e, and the sixth section 115f that are close to the junction of the first area and the second area. An installation area of the DC+ terminal 130 is disposed in the peripheral area of at least one of the seventh section 111a and the eighth section 111b that is close to the junction of the first area and the second area. An installation area of the DC- terminal 150 is disposed in the peripheral area of one or more of the tenth section 113b, eleventh section 113c, and twelfth section 113d that are close to the junction of the first and second areas. The AC terminal 170 is installed on the AC liner plate 115 in the installation area of the AC terminal 170, the DC+ terminal 130 is installed on the DC+ liner plate 111 in the installation area of the DC+ terminal 130, and the DC- terminal 150 is installed on the DC- liner plate 113 in the installation area of the DC- terminal 150.

In some embodiments, the DC+ terminal 130 includes the positive direct current pin 131, the positive terminal board 133, and the positive half bridge board 135. The positive terminal board 133 is spaced apart from the substrate 110. One end of the positive direct current pin 131 is connected to the positive terminal board 133, and the other end of the positive direct current pin 131 is connected to the DC+ liner plate 111 in the installation area of the DC+ terminal 130. The positive half bridge board 135 is disposed on the edge of the positive terminal board 133 close to the third side 110c, and extends along the direction away from the substrate 110. The DC- terminal 150 includes the negative direct current pin 151, the negative terminal board 153, and the negative half bridge board 155. The negative terminal board 153 is spaced apart from the substrate 110. One end of the negative direct current pin 151 is connected to the negative terminal board 153, and the other end of the negative direct current pin 151 is connected to the DC- liner plate 113 in the installation area of the DC- terminal 150. The negative half bridge plate 155 is disposed on the edge of the negative terminal board 153 close to the third side 1 10c, and extends along the direction away from the substrate 110. The AC terminal 170 includes the alternating current pin 171, the alternating current terminal board 173, and the AC half bridge board 175. The alternating current terminal board 173 is spaced apart from the substrate 110. One end of the alternating current pin 171 is connected to the alternating current terminal board 173, and the other end of the alternating current pin 171 is connected to the AC liner plate 115 in the installation area of the AC terminal 170. The AC half bridge board 175 is disposed on the edge of the alternating current terminal board 173 close to the third side 110c, and extends along the direction away from the substrate 110.

In some embodiments, the negative half bridge plate 155 and the positive half bridge plate 135 are sequentially spaced apart from each other along the first direction, and the distance between the negative half bridge plate 155 and the AC half bridge plate 175 is equal to the distance between the positive half bridge plate 135 and the AC half bridge plate 175.

In some embodiments, every two of the positive terminal board 133, the negative terminal board 153, and the alternating current terminal board 173 are spaced apart from each other. The distance between the positive terminal board 133 and the substrate 110, the distance between the negative terminal board 153 and the substrate 110, and the distance between the alternating current terminal board 173 and the substrate 110 are all equal.

In some embodiments, one end of the positive direct current pin 131 is connected to the edge of the positive terminal board 133 close to the negative terminal board 153, and the positive direct current pin 131 is bent and extends towards the first side 110a. That is, the positive direct current pin 131 first extends along a direction away from the positive terminal board 133 and close to the substate 110, and then extends along a direction close to the first side 110a. The other end of the positive direct current pin 131 is connected to the DC+ liner plate 111 in the terminal installation area. One end of the negative direct current pin 151 is connected to the edge of the negative terminal board 153 close to the positive terminal board 133, and the negative direct current pin 151 is bent and extends towards the second side 11 0b. That is, the negative direct current pin 151 first extends along a direction away from the negative terminal board 153 and close to the substate 110, and then extends along a direction close to the second side 110b. The other end of the negative direct current pin 151 is connected to the DC- liner plate 113 in the terminal installation area. One end of the alternating current pin 171 is connected to the edge of the alternating current terminal board 173 close to the first side 110a, and the alternating current pin 171 is bent and extends towards the second side 110b. That is, the alternating current pin 171 first extends along a direction away from the alternating current terminal board 173 and close to the substate 110, and then extends along the direction close to the second side 1 10b. The other end of the alternating current pin 171 is connected to the AC liner plate 115 in the terminal installation area.

In some embodiments, the present disclosure further provides yet another power semiconductor module 100, whose basic structure, principle, and technical effects are the same as those of the aforementioned power semiconductor module 100. For the sake of a brief description, the corresponding content in the aforementioned description of the power semiconductor module 100 may be referred to the parts not mentioned in the description of the yet another power semiconductor module 100.

As illustrated in FIG. 1, FIG. 2, and FIG. 10, the present disclosure further provides yet another power semiconductor module 100 including the substrate 110, the DC+ liner plate 111, the DC- liner plate 113, and the AC liner plate 115.

The substrate 110 includes the first side 110a and the second side 110b that are opposite to each other in the first direction, and the third side 110c and the fourth side 110d that are opposite to each other in the second direction. The first side 110a, the second side 110b, the third side 110c, and the fourth side 110d are connected end-to-end. In the first direction, the substrate 110 is configured as a first chip installation area and a second chip installation area that are opposite to each other, and a main terminal installation area between the first chip installation area and the second chip installation area. That is, the substrate 110 includes the first chip installation area, the second chip installation area, and the main terminal installation area. The first chip installation area is disposed on the side where the first side 110a is located, and the second chip installation area is disposed on the side where the second side 110b is located.

The DC+ liner plate 111, the DC- liner plate 113, and the AC liner plate 115 are disposed on the substrate 110. On the substrate 110, the DC+ liner plate 111, the DC- liner plate 113, and the AC liner plate 115 are configured to be isolated from one another or spaced apart from one another

The AC liner plate 115 includes a lower switch tube installation part 115g disposed in the second chip installation area, an AC terminal installation part 115h disposed in the main terminal installation area, and a first extension part 115i disposed in the first chip installation area. The lower switch tube installation part 115g, the AC terminal installation part 115h, and the first extension part 115i are integrated.

The DC+ liner plate 111 includes an upper switch tube installation part 111c disposed in the first chip installation area and a DC+ terminal installation part 111d disposed in the main terminal installation area. The upper switch tube installation part 111c and the DC+ terminal installation part 111d are integrated.

The DC- liner plate 113 includes a second extension part 113e disposed in the second chip installation area and a DC- terminal installation part 113f disposed in the main terminal installation area. The second extension part 113e and the DC- terminal installation part 113f are integrated.

In some embodiments, the DC+ liner plate 111 is configured to be surrounded by the AC liner plate 115, and the DC- liner plate 113 is configured to surround the AC liner plate 115.

In some embodiments, the main terminal installation area is provided with the AC terminal 170, the DC+ terminal 130, and the DC- terminal 150. The AC terminal 170 is disposed on the AC terminal installation part 115h, the DC+ terminal 130 is disposed on the DC+ terminal installation part 111d, and the DC- terminal 150 is disposed on the DC- terminal installation part 113f.

As illustrated in FIG. 3 to FIG. 6, in some embodiments, the DC+ terminal 130 includes the positive direct current pin 131, the positive terminal board 133, and the positive half bridge board 135. The positive terminal board 133 is spaced apart from the substrate 110. One end of the positive direct current pin 131 is connected to the positive terminal board 133, and the other end of the positive direct current pin 131 is connected to the DC+ terminal installation part 111d. The positive half bridge board 135 is disposed on the edge of the positive terminal board 133 close to the third side 110c, and extends along the direction away from the substrate 110. The DC- terminal 150 includes the negative direct current pin 151, the negative terminal board 153, and the negative half bridge board 155. The negative direct current pin 151 is spaced apart from the substrate 110. One end of the negative direct current pin 151 is connected to the negative terminal board 153, and the other end of the negative direct current pin 151 is connected to the DC- terminal installation part 113f. The negative half bridge plate 155 is disposed on the edge of the negative terminal board 153 close to the third side 110c, and extends along the direction away from the substrate 110. The AC terminal 170 includes the alternating current pin 171, the alternating current terminal board 173, and the AC half bridge board 175. The alternating current terminal board 173 is spaced apart from the substrate 110. One end of the alternating current pin 171 is connected to the alternating current terminal board 173, and the other end of the alternating current pin 171 is connected to the AC terminal installation part 115h. The AC half bridge board 175 is disposed on the edge of the alternating current terminal board 173 close to the third side 110c, and extends along the direction away from the substrate 110.

In some embodiments, the negative half bridge plate 155 and the positive half bridge plate 135 are sequentially spaced apart from each other along the first direction, and the distance between the negative half bridge plate 155 and the AC half bridge plate 175 is equal to the distance between the positive half bridge plate 135 and the AC half bridge plate 175.

In some embodiments, every two of the positive terminal board 133, the negative terminal board 153, and the Alternating current terminal board 173 are spaced apart from each other. The distance between the positive terminal board 133 and the substrate 110, the distance between the negative terminal board 153 and the substrate 110, and the distance between the alternating current terminal board 173 and the substrate 110 are all equal.

In some embodiments, one end of the positive direct current pin 131 is connected to the edge of the positive terminal board 133 close to the negative terminal board 153, and the positive direct current pin 131 is bent and extends towards the first side 110a. That is, the positive direct current pin 131 first extends along a direction away from the positive terminal board 133 and close to the substate 110, and then extends along a direction close to the first side 110a. The other end of the positive direct current pin 131 is connected to the DC+ liner plate 111 in the terminal installation area. One end of the negative direct current pin 151 is connected to the edge of the negative terminal board 153 close to the positive terminal board 133, and the negative direct current pin 151 is bent and extends towards the second side 110b. That is, the negative direct current pin 151 first extends along a direction away from the negative terminal board 153 and close to the substate 110, and then extends along a direction close to the second side 110b. The other end of the negative direct current pin 151 is connected to the DC- liner plate 113 in the terminal installation area. One end of the alternating current pin 171 is connected to the edge of the alternating current terminal board 173 close to the first side 110a, and the alternating current pin 171 is bent and extends towards the second side 110b. That is, the alternating current pin 171 first extends along a direction away from the alternating current terminal board 173 and close to the substate 110, and then extends along the direction close to the second side 1 10b. The other end of the alternating current pin 171 is connected to the AC liner plate 115 in the terminal installation area.

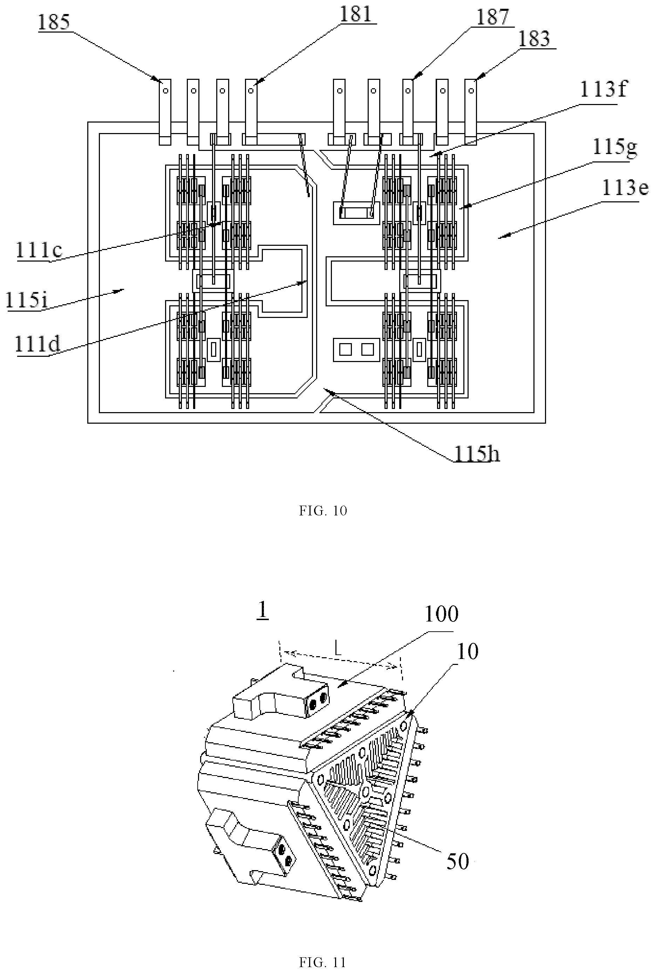

As illustrated in FIG. 3 and FIG. 10, in some embodiments, the power semiconductor module 100 further includes the isolation board 117 disposed between the DC+ terminal 130 and the DC- terminal 150.

In some embodiments, the lower switch tube installation part 115g and the upper switch tube installation part 111c are mirror symmetrical with respect to a mid-vertical plane of the third side 110c.

In some embodiments, the lower switch tube installation part 115g is provided with a first power chip 1151, and the upper switch tube installation part 111c is provided with a second power chip 1111.

In summary, in the power semiconductor module 100 provided by the embodiments of the present disclosure, the substrate 110 is divided into multiple areas. The substrate 110 is configured as the first area and the second area in the first direction. The DC+ liner plate 111, the DC- liner plate 113, and the AC liner plate 115 are disposed on the surface of the substrate 110. The DC+ liner plate 111, the DC- liner plate 113, and the AC liner plate 115 are isolated from one another or spaced apart from one another. The AC liner plate 115 is disposed in the first area and the second area. The AC liner plate 115 is configured to extend from the side of the first area close to the first side 110a to the second area. The DC+ liner plate 111 is disposed in the first area and configured to be surrounded by the AC liner plate 115. The DC- liner plate 113 is disposed in the second area and configured to surround the AC liner plate 115, making the layout more compact. Compared to the related art, in the power semiconductor module 100 in the embodiments of the present disclosure, the DC+ liner plate 111, the DC- liner plate 113, and the AC liner plate 115 can be reasonably arranged without interfering with one another, which facilitates wiring. Furthermore, the risk of the short circuit is reduced due to the minimized interference between the positive electrode and the negative electrode. Moreover, the AC liner plate 115 may be the single piece of copper-clad area that extends continuously from the first area to the second area of the substrate 110, avoiding the bonding structure caused by the split, further simplifying the layout of the wiring terminals, and reducing the difficulty of the manufacturing process.

As illustrated in FIG. 11 to FIG. 13, in some embodiments, the present disclosure provides a power module heat dissipation packaging structure 1, which adopts an encapsulated three-dimensional packaging form. The structure is compact, which is conducive to further reducing the volume, and the heat dissipation is more uniform, resulting in better heat dissipation effect. Furthermore, production and manufacturing costs are low, and efficiency of production and assembly is high.

The power module heat dissipation packaging structure 1 in the embodiments of the present disclosure includes a profile heat sink 10 and multiple power semiconductor modules 100 surrounding the profile heat sink 10. The profile heat sink 10 defines multiple heat dissipation channels 50 that are configured for flow of a cooling liquid. The profile heat sink 10 includes two opposite surfaces, the heat dissipation channels 50 penetrate the profile heat sink 10 and extend from one surface of two opposite surfaces of the heat dissipation channels 50 to the other surface of two opposite surfaces of the profile heat sink 10. Multiple bonding installation surfaces 70 are disposed on an outer peripheral surface of the profile heat sink 10, and the multiple power semiconductor modules 100 are affixed in a one-to-one correspondence to the multiple bonding installation surfaces 70.

In some embodiments, the power module heat dissipation packaging structure 1 is applicable to a motor controller 200. The motor controller 200 includes a control housing 210, a bus capacitor ring 230, and the power module heat dissipation packaging structure 1. After integration and packaging, the power module heat dissipation packaging structure 1 may be placed in the center of the bus capacitor ring 230. After assembled, entire structure is placed in the control housing 210. Furthermore, other electronic control components, such as a driving board, a control board, or the like, are also disposed in the control housing 210. After assembly, the motor controller 200 is formed. The basic structure and electronic control principle of the motor controller 200 may be referred to descriptions in related art.

In some embodiments, the power semiconductor modules 100 are fixed to the profile heat sink 10 in a surface-to-surface bonding manner. The profile heat sink 10 defines multiple heat dissipation channels 50 that are configured for flow of the cooling liquid. The profile heat sink 10 includes two opposite surfaces, the heat dissipation channels 50 penetrate the profile heat sink 10 and extend from one surface of two opposite surfaces of the heat dissipation channels 50 to the other surface of two opposite surfaces of the profile heat sink 10. The multiple bonding installation surfaces 70 are disposed on the outer peripheral surface of the profile heat sink 10, and the multiple power semiconductor modules 100 are affixed in a one-to-one correspondence to the multiple bonding installation surfaces 70. The multiple power semiconductor modules 100 adopt an encapsulated three-dimensional assembly scheme, which is more compact in structure compared to the conventional parallel flat scheme. The heat dissipation channels 50 can uniformly dissipate heat to the multiple power semiconductor modules 100, and the heat dissipation uniformity is better.

In some embodiments, the profile heat sink 10 may be made of a material with good thermal conductivity, such as aluminum, copper, or the like. The power semiconductor module 100 is directly attached or affixed to the bonding installation surface 70 of the profile heat sink 10, which may achieve low thermal resistances on paths from the power semiconductor modules 100 to the heat dissipation channels 50. Therefore, the power semiconductor modules 100 can be efficiently cooled. Moreover, the power semiconductor modules 100 are respectively located on bonding installation surfaces 70 independent to each other, the heat dissipation of the power semiconductor modules 100 has no mutual influence, and the heat dissipation is uniform.

The profile heat sink 10 includes a profile heat exchanger tube 11 and a supporting partition plate 13. The supporting partition plate 13 is disposed inside the profile heat exchanger tube 11 and divides interior of the profile heat exchanger tube 11 into the multiple heat dissipation channels 50. The bonding installation surfaces 70 are disposed on the outer surface of the profile heat exchanger tube 11, so that the power semiconductor modules 100 are affixed on the profile heat exchanger tube 11. In some embodiments, the supporting partition 13 may be integrated inside the profile heat exchanger tube 11, and there may be three heat dissipation channels 50. The supporting partition 13 is Y-shaped. The profile heat exchanger tube 11 may be triangular prism shaped, so that the power semiconductor modules 100 and the profile heat sink 10 are integrated and packaged into three half bridge modules required for an inverter of the motor controller 200 of the new energy vehicle. The three power semiconductor modules 100 are respectively located on three bonding installation surfaces 70 of the triangular prism profile heat exchanger tube 11. The bonding installation surfaces 70 are side surfaces of the profile heat exchanger tube 11, and the power semiconductor modules 100 may be directly welded to the bonding installation surfaces 70. In some embodiments, the profile heat exchanger tube 11 may has other shapes, such as a rectangular prism, a hexagonal prism, or the like, so as to integrate different numbers of power semiconductor modules 100. The present embodiment only takes the triangular prism as an example to illustrate, which does not limit the present disclosure.

As illustrated in FIG. 7, in some embodiments, the power semiconductor module 100 may also be a single-phase power semiconductor module 100 with a flat heat dissipation substrate 90, and the single-phase power semiconductor module 100 is able to be independently installed. The single-phase power semiconductor module 100 may be attached and installed on the surface of the profile heat exchanger tube 11 through the heat dissipation substrate 90. In some embodiments, the single-phase power semiconductor module 100 may be integrated with the profile heat exchanger tube 11 through a mechanical structure. In some embodiments, a screw hole 191 may be disposed at each of four apex corners of the heat dissipation substrate 90, and fixing is performed by using assembling screws. Therefore, the fixing effect is good. The single-phase power semiconductor module 100 may be disassembled, which is easy to replace and repair.

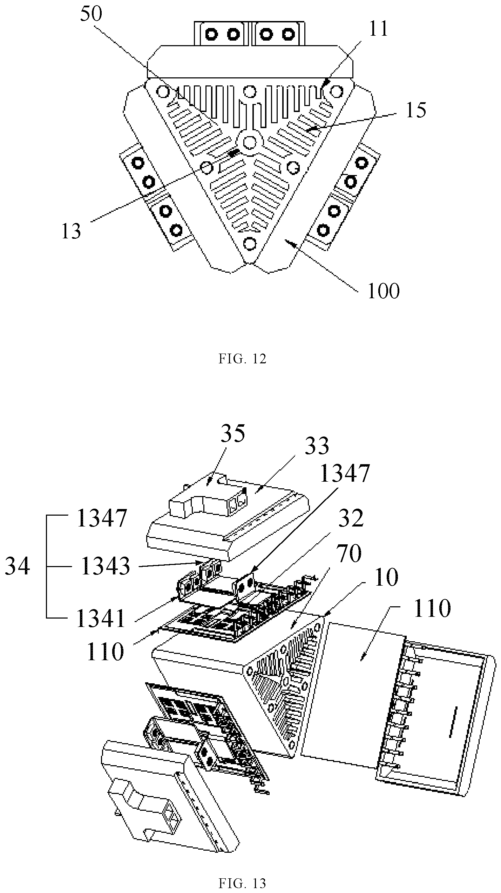

As illustrated in FIG. 7 and FIG. 13, the power semiconductor module 100 includes the substrate 110, a chip 32, and the housing 33. One side surface of the substrate 110 is disposed on the bonding installation surface 70, and the chip 32 is disposed on the other side surface of the substrate 110. The housing 33 is disposed on the substrate 110 and defines an accommodating chamber. The chip 32 is accommodated in the accommodating chamber. An external terminal assembly 34 is further disposed on the substrate 110. The external terminal assembly 34 is partially accommodated in the accommodating chamber and extends out of the housing 33. The accommodating chamber is also filled with a thermal conductive adhesive layer. In some embodiments, a material of the thermal conductive adhesive layer may be thermal conductive silicone or other filling materials with thermal conductivity. By filling the thermal conductive adhesive layer in the accommodating chamber, the sealing of the accommodating chamber can be improved, and the structural stability of the chip 32 and the external terminal assembly 34 can be improved. The chip 32 may be multiple and may achieve different functions. The installation process and structure of the chip 32 are consistent with installation technology of the conventional chip 32, which is not repeated here.

The external terminal assembly 34 includes a first direct current bus terminal 1341, a second direct current bus terminal 1343, and an alternating current bus terminal 1345. The housing 33 is also provided with a housing protrusion 35, and two ends of the housing protrusion 35 are respectively provided with a direct current port and an alternating current port that are communicated with the accommodating chamber. An opening direction of the direct current port and an opening direction of the alternating current port are perpendicular to the bonding installation surface 70. The first direct current bus terminal 1341 and the second direct current bus terminal 1343 are correspondingly welded to the substrate 110 and extend to the direct current port. The alternating current bus terminal 1345 is correspondingly welded to the substrate 110 and extends to the alternating current port. In some embodiments, the first direct current bus terminal 1341, the second direct current bus terminal 1343, and the alternating current bus terminal 1345 are all copper bar structures. The first direct current bus terminal 1341 may be a positive direct current (DC+) bus terminal, and the second direct current bus terminal 1343 may be a negative direct current (DC-) bus terminal. The housing protrusion 35 is provided with the direct current port and the alternating current port, the direct current port and the alternating current port respectively face two ends of a flow direction of the cooling liquid. A terminal nut is disposed in each of the direct current port and the alternating current port, and the terminal nut is embedded in the housing protrusion 35. It can prevent the terminal nut from rotating with a tightening action. Each main circuit copper bar terminal may be provided with two terminal nuts, so as to improve the reliability of electrical connections, reduce the resistance of connection points, and reduce temperature rise.

In some embodiments, the housing 33 partially protrudes to form the housing protrusion 35, and the housing protrusion 35 corresponds to the external terminal assembly 34 inside the housing 33. In some embodiments, the first direct current bus terminal 1341, the second direct current bus terminal 1343, and the alternating current bus terminal 1345 extend to an inner cavity of the housing protrusion 35. In some embodiments, the first direct current bus terminal 1341 and the second direct current bus terminal 1343 are arranged in parallel and protrude from the substrate 110, and extend to one side of the inner cavity of the housing protrusion 35, so that the first direct current bus terminal 1341 and the second direct current bus terminal 1343 correspond to and are connected to the direct current port. The alternating current bus terminal 1345 protrudes from the substrate 110 and extends to the other side of the inner cavity of the housing protrusion 35, so that the alternating current bus terminal 1345 corresponds to and is connected to the alternating current port. By adapting the external terminal assembly 34 to the inner cavity of the housing protrusion 35, a protrusion range of the housing protrusion 135 can be prevented from being too large, which can further save the overall space.

In some embodiments, the external terminal assembly 34 further includes multiple control terminal pins 1347. One side of the housing 33 defines multiple pin ports that are communicated with the accommodating chamber. The multiple pin ports are all disposed on a side of the housing protrusion 35, and the multiple control terminal pins 1347 are correspondingly welded to the substrate 110 and extend out of the multiple pin ports in a one-to-one correspondence. One end of each control terminal pin 1347 extending out of the pin port extends along a direction away from the housing protrusion 35, so that each control terminal pin 1347 is bent. In some embodiments, one end of the control terminal pin 1347 is connected to the substrate 110, and the other end of the control terminal pin 1347 extends upward out of the housing 33 in a bent shape. The multiple control terminal pins 1347 are concentrated on a side of the housing 33 and arranged along a direction away from the housing protrusion 35. The extension directions of the control terminal pins 1347 are not consistent with the connection directions of the direct current terminal and/or the alternating current terminal of the power semiconductor module 100, thereby weakening the electromagnetic interference of the control terminals and achieving better control effect. Furthermore, the control terminal pins 1347 of the three power semiconductor modules 100 all extend along the same direction, therefore, a single driving board may be adopted to control the three-dimensional integrated packaging structure during assembly, making assembly simpler and faster.

In some embodiments, the first direct current bus terminal 1341 and the second direct current bus terminal 1343 are arranged in parallel on the substrate 110. The isolation board 117 is further disposed on the substrate 110, and the isolation board 117 is disposed between the first direct current bus terminal 1341 and the second direct current bus terminal 1343. In some embodiments, the first direct current bus terminal 1341 and the second direct current bus terminal 1343 are disposed in parallel at the center of the accommodating chamber, and the first direct current bus terminal 1341 and the second direct current bus terminal 1343 are stacked in parallel. The isolation board 117 may be a plastic plate, which may achieve electrical isolation between the positive terminal and the negative terminal. Moreover, the structure is beneficial for the mutual cancellation of inductance of copper busbar terminals in the fast commutation process of the power semiconductor module 100. It can achieve lower stray inductance, effectively reduce the peak voltage during operation, and improve the device reliability. The first direct current bus terminal 1341 includes the DC+ terminal 130. The second direct current bus terminal 1343 includes the DC terminal. The alternating current bus terminal 1345 includes the AC terminal 170.

In some embodiments, the substrate 110 includes an insulating plate and a conductive layer. The insulating plate includes two opposite surfaces, one surface of the insulating plate is attached to the installation surface 70, and the conductive layer is disposed on the other surface of the insulating plate. The chip 32 is disposed on the conductive layer. In some embodiments, the insulating plate may be a ceramic substrate, the conductive layer may be a substrate copper layer covering the ceramic substrate, the chip 32 is welded to the substrate copper layer, and the substrate copper layer is welded to the ceramic substrate. The ceramic substrate is configured to achieve electrical isolation from the profile heat sink 10. The first direct current bus terminal 1341, the second direct current bus terminal 1343, the alternating current bus terminal 1345, and the control terminal (or gate terminal pin 187) are welded in the corresponding functional substrate copper covered area, so as to achieve electrical connection.

As illustrated in FIG. 11 to FIG. 13, in some embodiments, each heat dissipation channel 50 is provided with heat exchange fins 15. The heat exchange fins 15 extend from the interior of the profile heat exchanger tube 11 towards the middle of the heat dissipation channel 50. In some embodiments, the heat exchange fins 15 are integrated inside the profile heat exchange tube 11, which can further increase the heat exchange area, thereby improving the heat exchange efficiency between the cooling liquid and the profile heat exchange tube 11, and improving the heat dissipation effect on the power semiconductor module 100.

In some embodiments, multiple installation holes are defined on an end face of the profile heat exchanger tube 11, so that the profile heat exchanger tube 11 can be installed and fastened with other components of the motor controller 200, achieving mechanical connection and ensuring that the cooling liquid is in a sealed state.

In some embodiments, the profile heat sink 10 may be obtained by cutting and segmenting continuously extruded profiles, a cutting surface is perpendicular to an extending direction of the heat dissipation channel 50, thereby greatly reducing manufacturing cost and significantly improving production efficiency. A length L of the profile heat sink 10 can be flexibly adjusted according to parameter requirements of the power semiconductor module 100 and layout requirements of the internal components, so that the arrangement of different quantities and different functional components can adapt to the required space. It can quickly build a series of module products without the need for additional development of new molds for module heat sinks. The devices with different functional topologies may be welded onto the same profile heat sink 10, achieving flexible combination of different inverters and improving their applicability.

In some embodiments, the profile heat sink 10 may be formed by pressing powder metallurgy materials through molds.

In summary, the embodiments of the present disclosure provide a power module heat dissipation packaging structure 1. In the power module heat dissipation packaging structure 1, the multiple power semiconductor modules 100 described in the above embodiments surround the profile heat sink 10. The profile heat sink 10 defines multiple heat dissipation channels 50 that are configured for flow of the cooling liquid. The profile heat sink 10 includes two opposite surfaces, the heat dissipation channels 50 penetrate the profile heat sink 10 and extend from one surface of two opposite surfaces of the heat dissipation channels 50 to the other surface of two opposite surfaces of the profile heat sink 10. The multiple bonding installation surfaces 70 are disposed on the outer peripheral surface of the profile heat sink 10, and the multiple power semiconductor modules 100 are affixed in a one-to-one correspondence to the multiple bonding installation surfaces 70. The multiple power semiconductor modules 100 adopt the encapsulated three-dimensional assembly scheme, which is more compact in structure and smaller in volume compared to the conventional parallel flat scheme. The heat dissipation channels 50 can uniformly dissipate heat to the multiple power semiconductor modules 100, the heat dissipation uniformity is better, and the heat dissipation effect is better. Furthermore, the manufacturing cost of the profile heat sink 10 is low and the production efficiency is high. It can quickly build a series of module products without the need for additional development of new molds for module heat sinks. The devices with different functional topologies may be welded onto the same profile heat sink 10, achieving flexible combination of different inverters and improving their applicability.

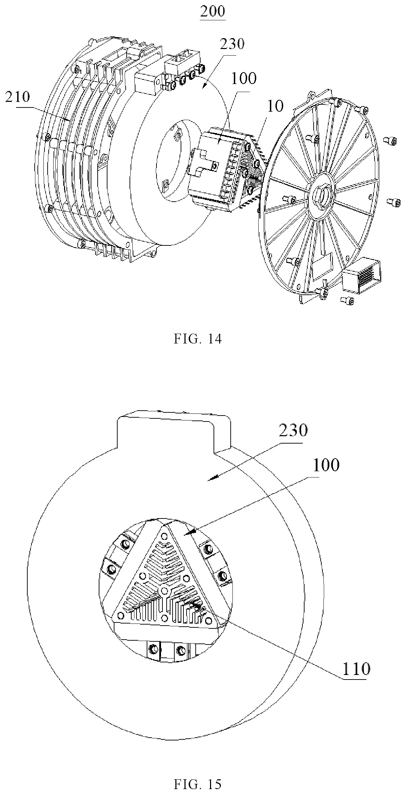

As illustrated in FIG. 14 and FIG. 15, in some embodiments, the present disclosure further provides the motor controller 200 including the control housing 210, the bus capacitor ring 230, and the power module heat dissipation packaging structure 1. The basic structure, the principle, and the technical effects of the power module heat dissipation packaging structure 1 are the same as those of the above embodiments. For a brief description, parts not mentioned in the present embodiment may refer to the corresponding content in the power heat dissipation packaging structure 100 provided in the above embodiments.

In some embodiments, the motor controller 200 includes the control housing 210, the bus capacitor ring 230, and the power module heat dissipation packaging structure 1. The bus capacitor ring 230 and the power module heat dissipation packaging structure 1 are accommodated in the control housing 210. The power module heat dissipation packaging structure 1 includes the profile heat sink 10 and the multiple power semiconductor modules 100 surrounding the profile heat sink 10. The profile heat sink 10 defines multiple heat dissipation channels 50 that are configured for flow of the cooling liquid. The profile heat sink 10 includes two opposite surfaces, the heat dissipation channels 50 penetrate the profile heat sink 10 and extend from one surface of two opposite surfaces of the heat dissipation channels 50 to the other surface of two opposite surfaces of the profile heat sink 10. The multiple bonding installation surfaces 70 are disposed on the outer peripheral surface of the profile heat sink 10, and the multiple power semiconductor modules 100 are affixed in a one-to-one correspondence to the multiple bonding installation surfaces 70. The profile heat sink 10 is disposed at the center of the bus capacitor ring 230, and the multiple power semiconductor modules 100 are disposed between the bus capacitor ring 230 and the profile heat sink 10.

In some embodiments, the power module heat dissipation packaging structure 1 after three-phase three-dimensional integrated packaging may be directly assembled at the center of the ring-shaped bus capacitor ring 230. The first direct current bus terminal 1341 and the second direct current bus terminal 1343 are directly connected to the wiring terminals on the capacitor. The alternating current output power terminal may be outputted along a radial direction of the bus capacitor ring 230, and the alternating current output power terminal is tightly attached to the bus capacitor ring 230, which greatly reduces the space of transfer and layout of the power bus of the motor controller 200, further reducing the volume of the motor controller 200, and improving the power density of the motor controller 200.

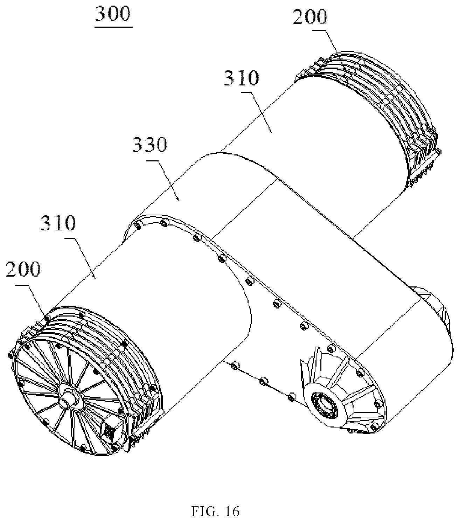

As illustrated in FIG. 16, in some embodiments, the present disclosure provides an electric drive assembly 300 including a motor 310 and the motor controller 200. The basic structure, the principle, and the technical effects of the motor controller 200 are the same as those of the above embodiments. For a brief description, parts not mentioned in the present embodiment may refer to the corresponding content of the motor controller 200 in the above embodiments.

The electric drive assembly 300 includes the motor 310 and the motor controller 200. The motor controller 200 includes the control housing 210, the bus capacitor ring 230, and the power module heat dissipation packaging structure 1. The control housing 210 is joined to an end cover of each end the motor 310, and the bus capacitor ring 230 and the power module heat dissipation packaging structure 1 are accommodated in the control housing 210. The power module heat dissipation packaging structure 1 includes the profile heat sink 10 and the multiple power semiconductor modules 100 surrounding the profile heat sink 10. The profile heat sink 10 defines multiple heat dissipation channels 50 that are configured for flow of the cooling liquid. The profile heat sink 10 includes two opposite surfaces, the heat dissipation channels 50 penetrate the profile heat sink 10 and extend from one surface of two opposite surfaces of the heat dissipation channels 50 to the other surface of two opposite surfaces of the profile heat sink 10. The multiple bonding installation surfaces 70 are disposed on the outer peripheral surface of the profile heat sink 10, and the multiple power semiconductor modules 100 are affixed in a one-to-one correspondence to the multiple bonding installation surfaces 70. The profile heat sink 10 is disposed at the center of the bus capacitor ring 230, and the multiple power semiconductor modules 100 are disposed between the bus capacitor ring 230 and the profile heat sink 10.

In some embodiments, the electric drive assembly 300 further includes a reducer 330, and the number of the motors 310 is two. The two motors 310 are disposed on two opposite sides of the reducer 330 and extend along opposite directions, respectively. Each end of the motor 310 away from the reducer 330 is provided with the end cover. In some embodiments, a set of motor 310 and motor controller 200 are installed on two opposite sides of the reducer 330, respectively, so that two sets of electric drive systems are formed. Each of the two sets of electric drive systems may drive one shaft, thereby achieving decoupling of parallel driving of multiple motors 310.

In some embodiments, the motor controller 200 is disposed on the end of the motor 310, avoiding the installation of the motor controller 200 on a top of the motor 310, thereby reducing a vertical space occupied by the electric drive assembly 300 and deepening a bottom space of the vehicle's trunk. Alternatively, a diameter of the motor 310 can be increased, so as to improve the torque and the power of the motor 310. Furthermore, the motor controller 200 is independently installed on the end of the motor 310, so that the high-frequency high-power semiconductor module 100 of the motor controller 200 are away from other power conversion systems and control systems, avoiding electromagnetic compatibility issues between various systems. Moreover, the motor controller 200 may be independently disassembled and maintained from the end of the motor 310, and entire vehicle suspension does not need to be disassembled, thereby saving maintenance time. The motor controller 200 is directly connected to the end of the motor 310 and electrically connected to a cable of the motor 310, so that an independent three-phase alternating current power cable may be omitted.

The above embodiments are only the specific implementation method of the present disclosure. However, the protection scope of the present disclosure is not limited to the above embodiments. Any those of ordinary skill in the art can easily think of changes or substitutions within the technical scope disclosed in the present disclosure should be covered by the protection scope of the present disclosure. Therefore, the protection scope of the present disclosure should be subject to the protection scope of the claims.

## Claims

1. A power semiconductor module (100), **characterized by** comprising:
a substrate (110), comprising a first side (110a) and a second side (10b) opposite to each other in a first direction, a third side (110c) and a fourth side (1 10d) opposite to each other in a second direction, wherein the first side (110a), the second side (10b), the third side (110c) and the fourth side (110d) are connected end-to-end; in the first direction, the substrate (110) is configured as a first area and a second area opposite to each other; and the first area is disposed on a side where the first side (10a) is located, and the second area is disposed on a side where the second side (110b) is located; and
a DC+ liner plate (111), a DC- liner plate (113), and an AC liner plate (115) disposed on the substrate (110), wherein the DC+ liner plate (111), the DC- liner plate (113), and the AC liner plate (115) are configured to be electrically isolated from one another on the substrate (110);
wherein the AC liner plate (115) is disposed in the first area and the second area, and configured to extend from a side of the first area close to the first side (110a) to the second area;
the DC+ liner plate (111) is disposed in the first area and configured to be surrounded by the AC liner plate (115); and
the DC- liner plate (113) is disposed in the second area and configured to surround the AC liner plate (115).

2. The power semiconductor module (100) according to claim 1, wherein a terminal installation area is disposed in a peripheral area where the first area is connected to the second area; an AC terminal (170), a DC+ terminal (130), and a DC- terminal (150) are disposed in the terminal installation area; and the AC terminal (170) is disposed on the AC liner plate (115) in the terminal installation area, the DC+ terminal (130) is disposed on the DC+ liner plate (111) in the terminal installation area, and the DC- terminal (150) is disposed on the DC- liner plate (113) in the terminal installation area.

3. The power semiconductor module (100) according to claim 2, wherein
the DC+ terminal (130) comprises a positive direct current pin (131), a positive terminal board (133), and a positive half bridge board (135); the positive terminal board (133) is spaced apart from the substrate (110); one end of the positive direct current pin (131) is connected to the positive terminal board (133), and the other end of the positive direct current pin (131) is connected to the DC+ liner plate (111) in the terminal installation area; and the positive half bridge plate (135) is disposed on an edge of the positive terminal board (133) close to the third side (110c) and extends along a direction away from the substrate (110);
the DC- terminal (150) comprises a negative direct current pin (151), a negative terminal board (153), and a negative half bridge board (155); the negative terminal board (153) is spaced apart from the substrate (110); one end of the negative direct current pin (151) is connected to the negative terminal board (153), and the other end of the negative direct current pin (151) is connected to the DC- liner plate (113) in the terminal installation area; and the negative half bridge plate (155) is disposed on an edge of the negative terminal board (153) close to the third side (110c) and extends along the direction away from the substrate (110); and
the AC terminal (170) comprises an alternating current pin (171), an alternating current terminal board (173), and an AC half bridge board (175); the alternating current terminal board (173) is spaced apart from the substrate (110); one end of the alternating current pin (171) is connected to the alternating current terminal board (173), and the other end of the alternating current pin (171) is connected to the AC liner plate (115) in the terminal installation area; and the AC half bridge board (175) is disposed on an edge of the alternating current terminal board (173) close to the third side (110c), and extends along the direction away from the substrate (110).

4. The power semiconductor module (100) according to claim 3, wherein the negative half bridge plate (155) and the positive half bridge plate (135) are sequentially spaced along the first direction, and a distance between the negative half bridge plate (155) and the AC half bridge plate (175) is equal to a distance between the positive half bridge plate (135) and the AC half bridge plate (175).

5. The power semiconductor module (100) according to claim 3, wherein every two of the positive terminal board (133), the negative terminal board (153), and the alternating current terminal board (173) are spaced apart from each other; and
a distance between the positive terminal board (133) and the substrate (110), a distance between the negative terminal board (153) and the substrate (110), and a distance between the alternating current terminal board (173) and the substrate (110) are all equal.

6. The power semiconductor module (100) according to claim 5, wherein
one end of the positive direct current pin (131) is connected to an edge of the positive terminal board (133) close to the negative terminal board (153), and the positive direct current pin (131) first extends along a direction away from the positive terminal board (133) and close to the substate (110), and then extends along a direction close to the first side (110a); and the other end of the positive direct current pin (131) is connected to the DC+ liner plate (111) in the terminal installation area;
one end of the negative direct current pin (151) is connected to an edge of the negative terminal board (153) close to the positive terminal board (133), and the negative direct current pin (151) first extends along a direction away from the negative terminal board (153) and close to the substate (110), and then extends along a direction close to the second side (110b); and the other end of the negative direct current pin (151) is connected to the DC- liner plate (113) in the terminal installation area; and
one end of the alternating current pin (171) is connected to an edge of the alternating current terminal board (173) close to the first side (110a), and the alternating current pin (171) first extends along a direction away from the alternating current terminal board (173) and close to the substate (110), and then extends along the direction close to the second side (110b); and the other end of the alternating current pin (171) is connected to the AC liner plate (115) in the terminal installation area.

7. The power semiconductor module (100) according to any one of claims 1-3, wherein the power semiconductor module further comprises an isolation board (117) disposed between the DC+ terminal (130) and the DC- terminal (150).

8. The power semiconductor module (100) according to claim 1, wherein
the AC liner plate (115) comprises a first section (115a) disposed in the first area, a second section (115b) disposed in the first area, a third section (115c) disposed in the first area, a fourth section (115d) disposed in the second area, a fifth section (115e) disposed in the second area, and a sixth section (115f) disposed in the first area; the first section (115a) is disposed close to the first side (110a) and extends along the second direction; the second section (115b) and the third section (115c) respectively extend from two opposite sides of the first section (115a) in the second direction, and are configured to extend towards the second area along the third side (110c) and the fourth side (110d), respectively; the fourth section (115d) and the fifth section (115e) extend from the second section (115b) and the third section (115c), respectively; at a junction of the first area and the second area, the fourth section (115d) and the fifth section (115e) are integrated along the second direction, and the sixth section (115f) extends from a middle section of the first section (115a) in the second direction and extends towards the second area along the first direction;
the DC+ liner plate (111) comprises a seventh section (111a) and an eighth section (111b); and at the junction of the first area and the second area, the seventh section (111a) and the eighth section (111b) are integrated along the second direction; and
the DC- liner plate (113) comprises a ninth section (113a), a tenth section (113b), an eleventh section (113c), and a twelfth section (113d); the ninth section (113a) is disposed close to the second side (110b) and extends along the second direction; the tenth section (113b) and the eleventh section (113c) respectively extend from two opposite sides of the ninth section (113a) in the second direction, and are configured to extend towards the first area along the third side (110c) and the fourth side (110d), respectively; and the twelfth section (113d) extends from a middle section of the ninth section (113a) in the second direction and extends towards the first area along the first direction.

9. The power semiconductor module (100) according to claim 8, wherein the seventh section (111a) and the eighth section (111b) are mirror symmetrical with respect to a mid-vertical plane of the first side (10a), and the fourth section (115d) and the fifth section (115e) are mirror symmetrical with respect to a mid-vertical plane of the second side (110b).

10. The power semiconductor module (100) according to claim 8, wherein the fourth section (115d) and the fifth section (115e) are provided with a first power chip (1151), and the seventh section (111a) and the eighth section (111b) are provided with a second power chip (1111).

11. The power semiconductor module (100) according to claim 8, wherein a plurality of control terminal pins (180) are further disposed on an edge of the substrate (110) close to the fourth side (110d), and the plurality of control terminal pins (180) are bent along a direction away from the third side (110c).

12. The power semiconductor module (100) according to claim 11, wherein the plurality of control terminal pins (180) comprise a plurality of DC+ terminal pins (181), a plurality of DC- terminal pins (183), and a plurality of AC terminal pins (185); and the plurality of AC terminal pins (185) are connected to the third section (115c), the plurality of DC+ terminal pins (181) are connected to the seventh section (111a), and the plurality of DC- terminal pins (183) are connected to the eleventh section (113c).

13. A power semiconductor module (100), **characterized by** comprising:
a substrate (110), comprising a first side (110a) and a second side (10b) opposite each other in a first direction, a third side (110c) and a fourth side (110d) opposite each other in a second direction, wherein the first side (110a), the second side (10b), the third side (110c) and the fourth side (110d) are connected end-to-end; in the first direction, the substrate (110) is configured as a first chip installation area, a second chip installation area, and a main terminal installation area disposed between the first chip installation area and the second chip installation area; and the chip installation area is disposed on a side where the first side (10a) is located, and the second chip installation area is disposed on a side where the second side (110b) is located;
a DC+ liner plate (111), a DC- liner plate (113), and an AC liner plate (115), disposed on the substrate (110), wherein the DC+ liner plate (111), the DC- liner plate (113), and the AC liner plate (115) are configured to be isolated from each other on the substrate (110);
wherein the AC liner plate (115) comprises a lower switch tube installation part (115g) disposed in the second chip installation area, an AC terminal installation part (115h) disposed in the main terminal installation area, and a first extension part (115i) disposed in the first chip installation area; and the lower switch tube installation part (115g), the AC terminal installation part (115h), and the first extension part (115i) are integrated;
the DC+ liner plate (111) comprises an upper switch tube installation part (111c) disposed in the first chip installation area and a DC+ terminal installation part (111d) disposed in the main terminal installation area, and the upper switch tube installation part (111c) and the DC+ terminal installation part (111d) are integrated; and
the DC- liner plate (113) comprises a second extension part (113e) disposed in the second chip installation area and a DC- terminal installation part (113f) disposed in the main terminal installation area; and the second extension part (113e) and the DC- terminal installation part (113f) are integrated.

14. A power semiconductor module heat dissipation packaging structure (1), **characterized by** comprising:
a profile heat sink (10); and
a plurality of power semiconductor modules (100) according to any one of claims 1 to 12 or claim 13 surrounding the profile heat sink (10), wherein the profile heat sink defines a plurality of heat dissipation channels (50) configured for flow of a cooling liquid; the profile heat sink (10) comprises two opposite surfaces, and the heat dissipation channels (50) penetrate the profile heat sink 10 and extend from one of the two opposite surfaces to the other of the two opposite surfaces; and a plurality of bonding installation surfaces (70) are disposed on an outer peripheral surface of the profile heat sink (10), and the plurality of power semiconductor modules (100) are affixed in a one-to-one correspondence to the plurality of bonding installation surfaces (70).

15. A motor controller, **characterized by** comprising:
a control housing (210);
a bus capacitor ring (230); and
a power semiconductor module heat dissipation packaging structure (1) according to claim 14, wherein the bus capacitor ring (230) and the power semiconductor module heat dissipation packaging structure (1) are accommodated in the control housing (210), and the plurality of power semiconductor modules (100) are disposed between the busbar capacitor ring (230) and the profile radiator (10).
